# EUROPEAN PATENT SPECIFICATION

(11) **EP 0 765 493 B1**
(45) Date of publication and mention of the grant of the patent: **05.09.2001**
(21) Application number: 95911051.1
(22) Date of filing: 16.02.1995
(51) Int. Cl.: G03F 7/00

(54) **SELF-CONTAINED IMAGING ASSEMBLY AND METHOD FOR FORMING IMAGES THEREIN**
SELBSTENTHALTENE BILDZUSAMMENBAU UND VERFAHREN ZUR BILDHERSTELLUNG DAMIT
ENSEMBLE AUTONOME DE FORMATION D'IMAGES ET PROCEDE D'UTILISATION ASSOCIE

(30) Priority: 10.06.1994 US 258329
(43) Date of publication of application: 02.04.1997
(73) Proprietor: CYCOLOR, INC., Miamisburg, Ohio 45342 (US)
(72) Inventor: BRAMMER, S., Thomas, Dayton,OH 45440 (US); CAMILLUS, Joseph, C. The Mead Corporation, Dayton,OH 45463 (US); JOHNSON, Mark, A. The Mead Corporation, Dayton, OH4546H3 (US); LIPPKE, William, Dayton, OH 45439 (US); TAYLOR, John, M. The Mead Corporation, Dayton, OH 45463 (US); TERRY, Darrell, A. The Mead Corporation, Dayton, OH 45463 (US)
(74) Representative: Deans, Michael John Percy
(86) International application number: PCT/US95/02095
(87) International publication number: WO 95/34845

(56) References cited:
- EP-A- 0 284 446
- DE-A- 3 923 016
- US-A- 4 535 050
- US-A- 4 897 334
- US-A- 4 920 026
- US-A- 5 212 040
- RESEARCH DISCLOSURE, vol. 276, HAVANT GB, pages 216-217, E. NELSON 'Two sheet adhered imaging system'
- PATENT ABSTRACTS OF JAPAN vol. 13 no. 271 (P-889) [3619] ,22 June 1989 & JP,A,01 063948 (BROTHER IND LTD) 9 March 1989,
- PATENT ABSTRACTS OF JAPAN vol. 12 no. 483 (P-802) [3330] ,16 December 1988 & JP,A,63 199344 (SEIKO INSTR & ELECTRONICS LTD) 17 August 1988,

## Description

The present invention relates to a self-contained imaging assembly. We describe hereinbelow improved such self-contained imaging assemblies which may be image-wise exposed to actinic radiation and subjected to an uniform rupturing force to provide an image which is visible against a second opaque support when viewed through a first transparent support or, if the second support is transparent, the image may be viewed as a transparency.

Photohardenable imaging systems employing microencapsulated radiation sensitive compositions are the subject of our US Patent Nos: 4 399 209 and 4 416 966 as well as copending US Patent Application Ser. No: 320 643, filed January 18, 1982. These imaging systems are characterized in that an imaging sheet including a layer of microcapsules containing a photohardenable or photosoftenable photohardenable composition in the internal phase is image-wise exposed to actinic radiation. In the most typical embodiments, the photohardenable composition is a photopolymerizable composition including a polyethylenically unsaturated compound and a photoinitiator and is encapsulated with a colour former. Exposure to actinic radiation hardens the internal phase of the microcapsules. Following exposure, the imaging sheet is subjected to a uniform rupturing force by passing the sheet through the nip between a pair of pressure rollers.

US Patent No: 4 535 050 to Adair *et al* discloses an arrangement for exposing and developing photosensitive sheets employing a microencapsulated radiation sensitive composition. A cover sheet is adhered to a layer of the microcapsules and following exposure the cover sheet is peeled away to rupture the microcapsules and develop the image.

US Patent No: 4 920 026 to Hagihara e*t al* is concerned with an arrangement in which two sheets are superposed together before being exposed to an image forming beam of light. A light-accepting sheet has a transparent colourless base sheet coated with microcapsules encapsulating a colourless dye and a photopolymerising agent which hardens upon exposure to light. An image transfer sheet is ccated with a developing agent having a chromogenic effect on this colourless dye. The microcapsules are selectably hardened by the image forming beam to form an invisible image which turns into a visible image when the superposed sheets are pressed together to rupture only those of the microcapsules which were not hardened. The light-accepting sheet and image transfer sheet may be separate but superimposed for imaging and then separated again or may be superposed from the beginning to be stored and delivered to be exposed together as a combined light and pressure sensitive image formation sheet, but in this latter case the two sheets are separated after formation of the visible image.

Our US Patent No: 4 440 846 discloses a self-contained imaging sheet in which the encapsulated colour former and the developer material are co-deposited on one surface of a single substrate as one layer or as two contiguous layers. Upon passing the self-contained copy sheet through pressure rollers in contact with the copy sheet, the microcapsules image-wise rupture and release internal phase whereupon the colour former migrates to the developer material where it reacts with the developer material and forms a coloured image.

US Patent No: 4 766 050 teaches an imaging system comprising a support, a layer containing microcapsules, a layer of developer material, and a layer containing an opacifying agent. The opacifying agent can form a separate layer or can be part of the layer containing the microcapsules or both.

In accordance with the present invention, in a first aspect thereof, we provide a self-contained photohardenable imaging assembly comprising a first transparent support, a second support which may be transparent or opaque, and an imaging layer disposed between said first transparent support and said second support; characterised in that said imaging layer consists essentially of a developer material and a plurality of photohardenable microcapsules, said microcapsules containing a colour former and a photohardenable composition; and in that said imaging assembly is sealed.

In this arrangement the imaging layer consists essentially of developer and microcapsules. Unlike the system of US 4 766 050, an opacifying agent when present is incorporated into a support, namely, the second support which provides a background for the image ultimately formed in the microcapsule layer. Upon image-wise exposure, the microcapsules are ruptured and the colour former is image-wise released from the ruptured microcapsules. It passes to the developer material, which is present in the same imaging layer, with which it reacts to form an image which is visible against the opaque second support when viewed through the transparent first support.

In another arrangement, both the first support and the second support are transparent allowing the image to be viewed as a transparency through a projector such as an overhead projector or a slide projector.

Having the imaging system sealed between the two support members which form the upper and lower layers prevents the developer material and the chemicals in the microcapsules from contacting persons during handling and, depending on the nature of the supports, may prevent oxygen from permeating into the photohardenable material. This format also provides a glossy "photographic" image.

It will thus be seen that the present invention enables the provision of an improved and convenient self-contained imaging assembly which provides an image against a white background as viewed through a transparent support or provides a transparency when both front and back supports are transparent, and which is sealed to prevent contact of irritating chemicals by persons handling the assembly.

Where the first support is coated on one surface with the imaging layer comprising a developer material and photohardenable microcapsules and the second support is coated on one surface with an adhesive, the first support is bonded to the second support such that the layer containing the developer and the microcapsules is disposed in a facing relation with the adhesive layer to form a laminate. In accordance with this embodiment wherein the first support is opaque, the colour former, upon rupture of the microcapsules, reacts with the developer material to form an image which is visible against the opaque support when viewed through the transparent support. In accordance with the embodiment wherein both first and second supports are transparent, the image may be viewed as a transparency.

In a second and alternative aspect of this invention, we provide a method for forming images in a self-contained photohardenable imaging assembly comprising the steps of: image-wise exposing a self-contained photosensitive imaging assembly to a source of actinic radiation, said self-contained photohardenable imaging assembly comprising a first transparent support, a second support which may be transparent or opaque, and an imaging layer consistinc essentially of a developer material and a plurality of photohardenable microcapsules, said microcapsules containing a colour former and a photohardenable composition, disposed between said first transparent support and said second support, and said assembly being sealed; subjecting said exposed, self-contained, photohardenable imaging assembly to a uniform rupturing force to cause said photohardenable microcapsules to rupture and image-wise transfer said colour former to said developer thereby forming an image; and viewing said image.

In the drawings:

FIG. 1 is a cross-sectional view of an embodiment of imaging system according to the present invention.

FIG. 2 is a cross-sectional view of FIG. 1 after exposure and microcapsule rupture.

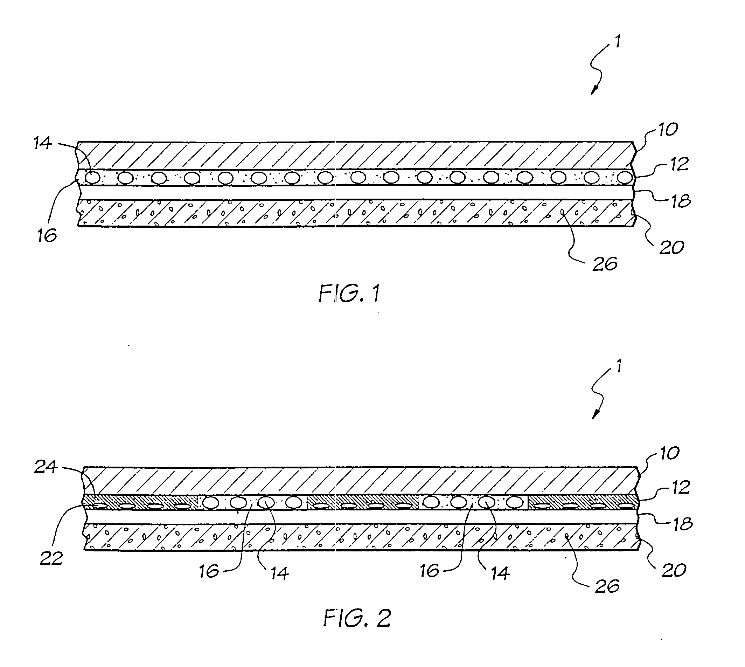

As illustrated in FIG. 1 and in accordance with one embodiment, a self-contained imaging system 1 comprises in order: a first transparent support 10, an imaging composition 12 comprising photohardenable microcapsules 14 and a developer material 16, a layer of adhesive 18, and a second support 20 which may or may not contain an opacifying agent 26. By image-wise exposing this unit to actinic radiation, the microcapsules are differentially hardened in the exposed areas as taught in U.S. patent Nos. 4,399,209 and 4,440,846. The exposed unit is subjected to pressure to rupture the microcapsules. FIG. 2 illustrates the self-contained imaging system of FIG. 1 after exposure and rupture of the microcapsules 14. Ruptured microcapsules 22 release a color forming agent which reacts with the developer material 16 to form an image 24. Typically, the microcapsules will consist of three sets of microcapsules sensitive to red, green and blue light and containing cyan, magenta and yellow formers, respectively, as taught in U.S. patent No. 4,772,541.

In the embodiment of Figs. 1 and 2, layer 12 contains a mixture of a developer material and photohardenable microcapsules. This layer typically contains about 20 to 80% (dry weight) of the developer, about 80 to 20% (dry weight) microcapsules and 0 to 20% binder. The layer is typically applied in a dry coat weight of about 8 to 20% g/cm². An example of such a coating formulation is illustrated in Example 2 below.

In the self-contained photohardenable imaging assembly as shown in FIG. 1, the first support 10 is preferably a transparent polyethylene terephthalate (PET) support coated on one surface with the aforesaid mixture. The second support 20 is preferably an opaque support such as polyethylene terephthalate (PET) containing an opacifying agent (black or white), paper or paper lined with film (polyethylene, polypropylene, polyester, etc.). Most perferably the opaque support is a polyethylene terephthalate support containing about 10% titanium dioxide to form a bright white colored opaque support. This support is commercially available from ICI, Ltd. under the product designation Melinex.

To assemble the second opaque support with the first transparent support, the second opaque support is coated on one surface with an adhesive 18. The first transparent support 10 is assembled with the second opaque support 20 such that the imaging layer 12 is disposed in a facing relation with the adhesive layer 18 to form a laminate. Upon exposure to actinic radiation followed by an application of uniform rupturing force, an image is formed which is viewed through the transparent support 10 against the bright white colored opaque support 20.

The adhesive useful in this present embodiment may be an aqueous-based adhesive such as Aerosett 2177 or Aerosett 2550 both of which are commercially available from Ashland Chemical Co., PD 0681, AP 6903, and W 3320 available from H.B. Fuller, or a solvent-based adhesive such as PS 508 sold by Ashland Chemical Co. The adhesives may be used separately or in combination. Preferably, the adhesive is transparent or translucent and most preferably it is a transparent aqueous- based adhesive which remains clear even after subjecting the assembly to radiation and pressure necessary to image-wise expose and rupture the microcapsules. The amount of the adhesive will vary depending on the nature of the adhesive and the support. The adhesive is generally applied in an amount of about 2 to 20 g/cm².

The first transparent support through which the image is viewed can be formed from any transparent polymeric film. A film will be selected which provides good photographic quality when viewing the image. Preferably, a film will be used which is resistant to yellowing. The preferred substrate useful in our self-contained imaging system is polyethylene terephthalate (PET) which is a clear polymeric material. Polyethylene terephthalate can be used unaltered as the first and second transparent supports when a transparency is desired. In a preferred embodiment, the opaque support is white polyethylene terephthalate which contains an opacifying agent as defined above. Typically, each of the PET supports has a thickness of about 2 to 4 mils.

In manufacturing the laminate, it is important not to rupture the microcapsules. This can be accomplished by laminating the layers of adhesive and developer/microcapsules between rubber rolls at a pressure which activates the adhesive but does not rupture the microcapsules.

In a preferred embodiment, the opaque second support is sufficiently opaque so that when a self-contained imaging sheet is exposed to radiation through the transparent support, the opague support is effective to prevent the radiation from penetrating to other imaging sheets which may be stacked behind the imaging sheet during the exposure step. However, if-the units are not exposed in a stacked formation, the opacity of the support is not critical so long as the support provides the desired background. When both supports are transparent, each self-contained imaging assembly must be separated from the other by an opaque member such as an opaque sheet or backing which is easily separated from the imaging sheet.

Generally, the opaque support will be available commercially. Some products which are useful include paper, cardboard, polyethylene, polyethylene-coated paper, etc. These products are composites or admixtures of the polymer and the pigment in a single layer, films or coated papers. Alternatively, the opacifying agent can be provided in a separate layer underlying or overlying a polymer film such as PET. The opacifying agent employed in these materials is an inert, light-reflecting material which exhibits a white opaque background. Materials useful as the opacifying agent include inert, light-scattering white pigments such as titanium dioxide, magnesium carbonate or barium sulfate. In a preferred embodiment the opacifying agent is titanium dioxide.

The bonding of the peripheral edges of the self-contained assembly can be accomplished by any of the conventional means used to seal polymeric materials such as polyethylene terephthalate. For example, films can be sealed using an adhesive or they may be heat sealed together or they can be sealed by any other technique. Preferably, the PET is sealed using a heat sealing method such as a heat knife. A white tape may be used to form a frame around the self-contained imaging assembly.

Useful photohardenable compositions, photoinitiators, chromogenic materials, carrier oils and encapsulation techniques for the microcapsules 14 are disclosed in U.S. Patent No. 4,399,209. Preferred photohardenable compositions are described in our U.S. Patent No. 4,772,541. The aforesaid photohardenable compositions are non-silver systems. Also useful in the present systems is a silver-based photohardenable microencapsulated system such as that described in U.S. Patents 4,912,011; 5,091,280 and 5,118,590 and other patents assigned to Fuji Photo Film Co.

In accordance with the preferred embodiments of the invention, a full colour imaging system is provided in which the microcapsules are sensitive to red, green, and blue light respectively. The photohardenable composition in at least one and possibly all three sets of microcapsules is sensitized by a cationic dye-borate anion complex as described in U.S. Patent 4,772,541. For optimum colour balance, the microcapsules are sensitive (λ max) at about 450 nm, 540 nm, and 650 mn, respectively. Such a system is useful with visible light sources in direct transmission or reflection imaging. Such a material is useful in making contact prints or projected prints of colour photographic slides. They are also useful in electronic imaging using lasers or pencil light sources of appropriate wavelengths.

Because the cationic dye-borate anion complexes absorb at wavelengths greater than 400 nm, they are coloured. The unexposed dye complex present in the microcapsules in the non-image areas can cause undesired colouration in the background area of the final picture. Typically, the mixture of microcapsules is green which gives the background areas a greenish tint. Means for preventing or reducing undesired colouration the background as well as the developed image include reducing the amount of photoinitiator used and adjusting the relative amounts of cyan, magenta and yellow microcapsules as shown in the examples which follow.

The photohardenable compositions can be encapsulated in various wall formers using techniques known in the area of carbonless paper including coacervation, interfacial polymerization, polymerization of one or more monomers in an oil, as well as various melting, dispersing, and cooling methods. To achieve maximum sensitivities, it is important that an encapsulation technique be used which provides high quality capsules which are responsive to changes in the internal phase viscosity in terms of their ability to rupture. Because the borate tends to be acid sensitive, encapsulation procedures conducted at higher pH (e.g., greater than about 6) are preferred.

Melamine-formaldehyde capsules are particularly useful. It is desirable to provide a pre-wall in the preparation of the microcapsules. See U.S. Patent 4,962,010 for a particularly preferred encapsulation using pectin and sulfonated polystyrene as system modifiers. The formation of pre-walls is known, however, the use of larger amounts of the polyisocyanate precursor is desired. A capsule size should be selected which minimizes light attenuation. The mean diameter of the capsules used typically ranges from approximately 1 to 25 microns. As a general rule, image resolution improves as the capsule size decreases. Technically, however, the capsules can range in size from one or more microns up to the point where they become visible to the human eye.

The developer materials and coating compositions containing the same conventionally employed in carbonless paper technology are useful in the present systems. Illustrative examples are clay minerals such as acid clay, active clay, attapulgite, etc.; organic acids such as tannic acid, gallic acid, propyl gallate, etc.; acid polymers such as phenol-formaldehyde resins, phenol acetylene condensation resins, condensates between an organic carboxylic acid having at least one hydroxy group and formaldehyde, etc.; metal salts of aromatic carboxylic acids or derivatives thereof such as zinc salicylate, tin salicylate, zinc 2-hydroxy napththoate, zinc 3,5 di-tert butyl salicylate, zinc 3,5-di-(a-methylbenzyl)salicylate., oil soluble metals salts or phenol-formaldehyde novolak resins (e.g., see U.S. Patent Nos. 3,672,935; 3,732,120 and 3,737,41) such as zinc modified oil soluble phenol-formaldehyde resin as disclosed in U.S. Patent No. 3,732,120, zinc carbonate etc. and mixtures thereof. The preferred developer material is one which will permit room temperature development such as zinc salicylate and particularly a mixture of zinc salicylate with a phenol formaldehyde resin. The particle size of the developer material is important to obtain a high quality image. The developer particles should be in the range of about 0.2 to 3 microns and, preferably in the range of about 0.5 to 1.5 microns. A suitable binder such as polyvinyl alcohol (PVA) is mixed with the developer, typically in an amount of about 1 to 8% by weight, to prepare a coating composition.

Microcapsules useful in practicing the present invention are preferably prepared and blended to form a photohardenable layer as illustrated in Example 1 below. The amount of photoinitiator in the microcapsules has been reduced and the ratio of cyan to magenta and yellow capsules has been adjusted to provide a layer with minimal tint so as not to distract from the whiteness of the background.

### EXAMPLE 1

Model Laboratory Capsule Preparation
1. Into a 600 ml stainless steel beaker, 110 g water and 4.6 g isobutylene maleic anhydride copolymer (dry) are weighed.
2. The beaker is clamped in place on a hot plate under an overhead mixer. A six-bladed, 45° pitch, turbine impeller is used on the mixer.
3. After thoroughly mixing, 4.0 g pectin (polygalacturonic acid methyl ester) is slowly sifted into the beaker. This mixture is stirred for 2 hours at room temperature (800-1200 rpm).
4. The pH is adjusted to 7.0 with 20% sulfuric acid.
5. The mixer is turned up to 3000 rpm and the internal phase is added over a period of 10-15 seconds. Emulsification is continued for 10 minutes. Magenta and yellow precursor phases are emulsified at 25°-30° C Cyan phase is emulsified at 45°-50° C (oil), 25°-30° C (water).
6. At the start of emulsification, the hot plate is turned up so heating continues during emulsification.
7. After 10 minutes, the pH is adjusted to 8.25 with 20% sodium carbonate, the mixing speed is reduced to 2000 rpm, and a solution of melamine-formaldehyde prepolymer is slowly added which is prepared by dispersing 3.9 g melamine in 44 g water, adding 6.5 g formaldehyde solution (37%) and heating at 60°C until the solution clears plus 30 minutes.
8. The pH is adjusted to 6.0, the beaker is covered with foil and placed in a water bath to bring the temperature of the preparation to 65% C. When 65°C is reached, the hot plate is adjusted to maintain this temperature for a two hour cure time during which the capsule walls are formed.
9. After curing, mixing speed is reduced to 600 rpm, formaldehyde scavenger solution (7.7 g urea and 7.0 g water) is added and the solution was cured another 40 minutes.
10. The pH is adjusted to 9.5 using a 20% NaOH solution and stirred overnight at room temperature.

Three batches of microcapsules were prepared as above for use in a full color imaging sheet using the three internal phase compositions set forth below.

| Yellow Capsule Internal Phase (420 nm) | |
|---|---|
| TMPTA | 35 g |
| DPHPA | 15 g |
| 3-thionyl-7-diethylaminocoumarin | 15 g |
| 2-Mercaptobenzoxazole (MBO) | 2.0 g |
| 2,6-Diisopropylaniline | 1.0 g |
| Reakt Yellow (BASF) | 5.0 g |
| Desmodur N-100 (Bayer Biuret Polyisocyanate Resin) | 3.33 g |

| Magenta Capsule Internal Phase (550 nm) | |
|---|---|
| TMPTA | 50 g |
| 1,1'-dibutylindocarbocyanine-methyltriphenylborate complex | 0.2 g |
| 2,6-Diisopropylaniline | 2.0 g |
| HD5100 (Magenta color precursor from Hilton-Davis Chemical Co.) | 12.0 g |

| Cyan Capsule Internal Phase (650 nm) | |
|---|---|
| TMPTA | 50 g |
| 1-1'-diheptylindocarbocyanine-hexyltriphenylborate complex | 0.31 g |
| 2,6-Diisopropylaniline | 2.0 g |
| Cyan Precursor (CP-177 of Hilton-Davis Chemical Co.) | 6 g |

Microcapsules prepared as above were used together with developers to prepare the following coating composition and coated on a PET support :

| | |
|---|---|
| Cyan Capsules | 36 g |
| Magenta Capsules | 30 g |
| Yellow Capsules | 34 g |
| Dow Binder | 10 g |
| Phenolic Resin (HRJ 4542 from Schenectady Chemical Co.) | 90 g |
| Polyvinylalcohol (airvol grade 205 from Air Products Co.) | 10 g |

A second PET support was placed over the coated composition and the two layers sealed at their edges using Ashland's PS 508 adhesive.

The imaging system can be exposed in any suitable camera or other exposure device to provide an image. The imaging system is especially suitable for exposure using a liquid crystal array or light emitting diodes driven by a video signal for the reproduction of images from a video cassette recorder, a camcorder.

## Claims

1. A self-contained photohardenable imaging assembly comprising a first transparent support, a second support which may be transparent or opaque, and an imaging layer disposed between said first transparent support and said second support; **characterised in that** said imaging layer consists essentially of a developer material and a plurality of photohardenable microcapsules, said microcapsules containing a colour former and a photohardenable composition; and in that said imaging assembly is sealed.

2. An assembly according to Claim 1, further **characterised in that** said first transparent support is a clear polyethylene terephthalate film and said second support is an opaque polyethylene terephthalate film containing a white pigment.

3. An assembly according to Claim 2, further **characterised in that** the white pigment is titanium dioxide.

4. An assembly according to Claim 1, further **characterised in that** said second support is a transparent film comprising a clear polyethylene terephthalate film.

5. An assembly according to any one of the preceding claims, further **characterised in that** said developer material comprises a phenolic resin.

6. An assembly according to Claim 5, further **characterised in that** said developer comprises zinc salicylate and phenol-formaldehyde resin.

7. An assembly according to any one of the preceding claims, further **characterised in that** said assembly is sealed by an adhesive material or by heat sealing.

8. An assembly according to Claim 7, further **characterised in that** said developer material, said plurality of photohardenable microcapsules, and said adhesive material are mixed and disposed as a single layer on said first support or said second support.

9. An assembly according to any of Claims 1 to 6, further **characterised in that** said imaging layer is disposed on one surface of either said first or said second support and a layer of adhesive is disposed on one surface of the other of said first and said second support, said imaging layer facing said adhesive layer such that said first support is sealed to said second support with said adhesive layer and said imaging layer therebetween.

10. An imaging assembly according to Claim 9, further **characterised in that** said imaging layer is provided on said first transparent support and said layer of adhesive is provided on said second support.

11. A method for forming images in a self-contained photohardenable imaging assembly comprising the steps of: image-wise exposing a self-contained photosensitive imaging assembly to a source of actinic radiation, said self-contained photohardenable imaging assembly comprising a first transparent support, a second support which may be transparent or opaque, and an imaging layer consisting essentially of a developer material and a plurality of photohardenable microcapsules, said microcapsules containing a colour former and a photohardenable composition, disposed between said first transparent support and said second support, and said assembly being sealed; subjecting said exposed, self-contained, photohardenable imaging assembly to a uniform rupturing force to cause said photohardenable microcapsules to rupture and image-wise transfer said colour former to said developer thereby forming an image; and viewing said image.

12. A method according to Claim 11, wherein said second support is a transparent film and said image is viewed as a transparency.

13. A method according to Claim 11, wherein said second support is an opaque polyethylene terephthalate film containing a white pigment and said image is viewed through said first transparent support, said opaque support providing a reflective background therefor.

14. A method according to Claim 13, wherein the white pigment is titanium dioxide.

15. A method according to any one of Claims 11 to 14, wherein said developer material, said plurality of photohardenable microcapsules and an adhesive material are mixed and disposed on a single layer on said first support or said second support.

16. A method according to any one of Claims 11 to 14, wherein said imaging layer is disposed on one surface of said first or said second support and a layer of adhesive is disposed on one surface of the other of said first and said second support, said imaging layer facing said adhesive layer.

17. A method according to Claim 16, wherein said imaging layer is provided on said first transparent support and said layer of adhesive is provided on said second transparent support.

## Patentansprüche

1. Integrale photohärtbare Bilderzeugungsanordnung, die einen ersten durchsichtigen Träger, einen zweiten Träger, der durchsichtig oder undurchsichtig sein kann, und eine zwischen dem ersten durchsichtigen Träger und dem zweiten Träger angeordnete bilderzeugende Schicht umfasst, **dadurch gekennzeichnet**, dass die bilderzeugende Schicht im Wesentlichen aus einem Entwicklermaterial und einer Vielzahl von photohärtbaren Mikrokapseln besteht, wobei die Mikrokapseln einen Farbbildner und eine photohärtbare Zusammensetzung enthalten, und dass die Bilderzeugungsanordnung versiegelt ist.

2. Anordnung gemäß Anspruch 1, **dadurch gekennzeichnet**, dass es sich bei dem ersten durchsichtigen Träger um einen Polyethylenterephthalat-Klarsichtfilm und bei dem zweiten Träger um einen undurchsichtigen Polyethylenterephthalat-Film handelt, der ein weißes Pigment enthält.

3. Anordnung gemäß Anspruch 2, **dadurch gekennzeichnet**, dass es sich bei dem weißen Pigment um Titandioxid handelt.

4. Anordnung gemäß Anspruch 1, **dadurch gekennzeichnet**, dass es sich bei dem zweiten Träger um einen durchsichtigen Film handelt, der einen Polyethylenterephthalat-Klarsichtfilm umfasst.

5. Anordnung gemäß einem der vorstehenden Ansprüche, **dadurch gekennzeichnet**, dass das Entwicklermaterial ein Phenolharz umfasst.

6. Anordnung gemäß Anspruch 5, **dadurch gekennzeichnet**, dass der Entwickler Zinksalicylat und Phenolformaldehydharz umfasst.

7. Anordnung gemäß einem der vorstehenden Ansprüche, **dadurch gekennzeichnet**, dass die Anordnung mit einem Klebstoff oder durch Wärmeversiegelung versiegelt ist.

8. Anordnung gemäß Anspruch 7, **dadurch gekennzeichnet**, dass das Entwicklermaterial, die Vielzahl an photohärtbaren Mikrokapseln und der Klebstoff vermischt und als Einzelschicht auf dem ersten Träger oder auf dem zweiten Träger angeordnet sind.

9. Anordnung gemäß einem der Ansprüche 1 bis 6, **dadurch gekennzeichnet**, dass die bilderzeugende Schicht auf einer Oberfläche des ersten oder des zweiten Trägers angeordnet ist, und eine Klebstoffschicht auf einer Oberfläche des jeweils anderen, ersten oder zweiten Trägers angeordnet ist, wobei die bilderzeugende Schicht zur Klebstoffschicht hin angeordnet ist, so dass zwischen den miteinander versiegelten ersten und zweiten Trägern die Klebstoffschicht und die bilderzeugende Schicht liegen.

10. Bilderzeugungsanordnung gemäß Anspruch 9, **dadurch gekennzeichnet**, dass die bilderzeugende Schicht auf dem ersten durchsichtigen Träger vorgesehen ist, und die Klebstoffschicht auf dem zweiten Träger vorgesehen ist.

11. Verfahren zur Bilderzeugung in einer integralen photohärtbaren Bilderzeugungsanordnung, umfassend die Schritte:
- bildentsprechende Belichtung einer integralen lichtempfindlichen Bilderzeugungsanordnung mit einer Quelle von photoaktiver Strahlung, wobei die integrale photohärtbare Bilderzeugungsanordnung einen ersten durchsichtigen Träger, einen zweiten Träger, der durchsichtig oder undurchsichtig sein kann, und eine bilderzeugende Schicht umfasst, die im Wesentlichen aus einem Entwicklermaterial und einer Vielzahl von photohärtbaren Mikrokapseln besteht, wobei die Mikrokapseln einen Farbbildner und eine photohärtbare Zusammensetzung enthalten, und die zwischen dem ersten durchsichtigen Träger und dem zweiten Träger angeordnet ist, wobei die Anordnung versiegelt ist,
- Anwendung einer gleichmäßigen Aufbrechkraft auf die belichtete integrale photohärtbaren Bilderzeugungsanordnung, um ein Aufbrechen der photohärtbaren Mikrokapseln und einen bildentsprechenden Transfer des Farbbildners auf den Entwickler zu bewirken, wodurch ein Bild erzeugt wird, und
- Betrachten des Bildes.

12. Verfahren gemäß Anspruch 11, in dem es sich bei dem zweiten Träger um einen durchsichtigen Film handelt, und das Bild als Transparenzbild betrachtet wird.

13. Verfahren gemäß Anspruch 11, in dem es sich bei dem zweiten Träger um einen undurchsichtigen Polyethylenterephthalat-Film handelt, der ein weißes Pigment enthält, und das Bild durch den ersten durchsichtigen Träger betrachtet wird, wobei der undurchsichtige Träger einen reflektierenden Hintergrund dafür bietet.

14. Verfahren gemäß Anspruch 13, in dem es sich bei dem weißen Pigment um Titandioxid handelt.

15. Verfahren gemäß einem der Ansprüche 11 bis 14, in dem das Entwicklermaterial, die Vielzahl an photohärtbaren Mikrokapseln und ein Klebstoff vermischt und als Einzelschicht auf dem ersten Träger oder auf dem zweiten Träger angeordnet sind.

16. Verfahren gemäß einem der Ansprüche 11 bis 14, in dem die bilderzeugende Schicht auf einer Oberfläche des ersten oder des zweiten Trägers angeordnet ist, und eine Klebstoffschicht auf einer Oberfläche des jeweils anderen, ersten oder zweiten Trägers angeordnet ist, wobei die bilderzeugende Schicht zur Klebstoffschicht hin angeordnet ist.

17. Verfahren gemäß Anspruch 16, in dem die bilderzeugende Schicht auf dem ersten durchsichtigen Träger vorgesehen ist, und die Klebstoffschicht auf dem zweiten durchsichtigen Träger vorgesehen ist.

## Revendications

1. Dispositif autonome de formation d'images photo-durcissant comprenant un premier support transparent, un second support qui peut être transparent ou opaque, et une couche d'impression disposée entre ledit premier support transparent et ledit second support; **caractérisé en ce que** ladite couche d'impression consiste essentiellement en un matériau révélateur et une pluralité de micro-capsules photo-durcissantes, lesdites micro-capsules contenant un chromogène et une composition photo-durcissante; et en ce que ledit dispositif de formation d'imageest scellé.

2. Dispositif selon la revendication 1, de plus **caractérisé en ce que** ledit premier support transparent est un film de polyéthylène téréphtalate transparent et ledit second support est un film de polyéthylène téréphtalate opaque contenant un pigment blanc.

3. Dispositif selon la revendication 2, de plus **caractérisé en ce que** ce pigment blanc est de l'anhydride titanique.

4. Dispositif selon la revendication 1, de plus **caractérisé en ce que** ledit second support est un film transparent comprenant un film de polyéthylène téréphtalate transparent.

5. Dispositif selon l'une quelconque des revendications précédentes, de plus **caractérisé en ce que** ledit matériau révélateur comprend une résine phénolique.

6. Dispositif selon la revendication 5, de plus **caractérisé en ce que** ledit révélateur comprend du salicylate de zinc et de la résine phénol-formaldéhyde.

7. Dispositif selon l'une quelconque des revendications précédentes, de plus **caractérisé en ce que** ledit dispositif est scellé par un matériau adhésif ou par thermoscellage.

8. Dispositif selon la revendication 7, de plus **caractérisé en ce que** ledit matériau révélateur, ladite pluralité de micro-capsules photo-durcissantes, et ledit matériau adhésif sont mélangés et disposés sous forme d'une couche unique sur ledit premier support ou ledit second support.

9. Dispositif selon l'une quelconque des revendications 1 à 6, de plus **caractérisé en ce que** ladite couche d'impression est disposée sur une surface dudit premier ou dudit second support et une couche adhésive est disposée sur l'autre surface dudit premier ou second support, ladite couche d'impression faisant face à ladite couche adhésive de telle sorte que ledit premier support est scellé audit second support avec ladite couche adhésive et ladite couche d'impression entre eux.

10. Dispositif de formation d'images selon la revendication 9, de plus **caractérisé en ce que** la couche d'impression est fournie sur ledit premier support transparent et ladite couche adhésive est fournie sur ledit second support.

11. Procédé de formation d'images dans un dispositif autonome de formation d'images photo-durcissant comprenant les étapes :
- d'exposition en ce qui concerne l'image d'un dispositif autonome de formation d'images photo-durcissant à une source de radiation actinique, ledit dispositif autonome de formation d'images photo-durcissant comprenant un premier support transparent, un second support qui peut être transparent ou opaque, et une couche d'impression consistant essentiellement en un matériau révélateur et une pluralité de micro-capsules photo-durcissantes, lesdites micro-capsules contenant un chromogène et une composition photo-durcissante, disposée entre ledit premier support transparent et ledit second support, et ledit dispositif étant scellé;
- de soumission dudit dispositif autonome de formation d'images photo-durcissant exposé à une force de rupture uniforme afin de provoquer la rupture desdites micro-capsules photo-durcissantes et le transfert en ce qui concerne l'image dudit chromogène audit révélateur formant de ce fait une image; et
- de visualisation de ladite image.

12. Procédé selon la revendication 11, dans lequel ledit second support est un film transparent et ladite image est vue par transparence.

13. Procédé selon la revendication 11, dans lequel ledit second support est un film de polyéthylène téréphtalate opaque contenant un pigment blanc et ladite image est vue à travers ledit premier support transparent, ledit support opaque fournissant un arrière-plan réfléchissant pour cela.

14. Procédé selon la revendication 13, dans lequel le pigment blanc est de l'anhydride titanique.

15. Procédé selon l'une quelconque des revendications 11 à 14, dans lequel ledit matériau révélateur, ladite pluralité de micro-capsules photo-durcissantes et un matériau adhésif sont mélangés et disposés en sous forme d'une couche unique sur ledit premier ou ledit second support.

16. Procédé selon l'une quelconque des revendications 11 à 14, dans lequel ladite couche d'impression est disposée sur une surface dudit premier ou dudit second support et une couche adhésive est disposée sur l'autre surface dudit premier ou dudit second support, ladite couche d'impression faisant face à ladite couche adhésive.

17. Procédé selon la revendication 16, dans lequel ladite couche d'impression est fournie sur ledit premier support transparent et ladite couche adhésive est fournie sur ledit second support transparent.
